(19) Europäisches Patentamt
European Patent Office
Office européen des brevets

(11) **EP 1 131 647 B1**

(12) **EUROPÄISCHE PATENTSCHRIFT**

(45) Veröffentlichungstag und Bekanntmachung des Hinweises auf die Patenterteilung:
**07.12.2005 Patentblatt 2005/49**

(51) Int Cl.⁷: **G01R 33/28**, G01R 33/36, G01R 33/31

(21) Anmeldenummer: **99955818.2**

(22) Anmeldetag: **30.09.1999**

(86) Internationale Anmeldenummer:
**PCT/DE1999/003148**

(87) Internationale Veröffentlichungsnummer:
**WO 2000/019228 (06.04.2000 Gazette 2000/14)**

(54) **PROBENKOPF FÜR EIN NMR-SPEKTROMETER**

PROBE HEAD FOR AN NMR SPECTROMETER

TETE DE SONDE POUR UN SPECTROMETRE A RESONANCE MAGNETIQUE NUCLEAIRE

(84) Benannte Vertragsstaaten:
**AT BE CH CY DE DK ES FI FR GB GR IE IT LI LU MC NL PT SE**

(30) Priorität: **30.09.1998 DE 19844895**

(43) Veröffentlichungstag der Anmeldung:
**12.09.2001 Patentblatt 2001/37**

(73) Patentinhaber: **Bergmann, Wilfried**
**56651 Niederdürenbach-Hain (DE)**

(72) Erfinder: **Bergmann, Wilfried**
**56651 Niederdürenbach-Hain (DE)**

(74) Vertreter: **Stute, Ivo Peter et al**
**Alt-Niederkassel 75**
**40547 Düsseldorf (DE)**

(56) Entgegenhaltungen:
**WO-A-98/19175**     **US-A- 3 769 618**
**US-A- 4 442 404**     **US-A- 5 258 710**

• **SANK V J ET AL: "A quadrature coil for the adult human head" JOURNAL OF MAGNETIC RESONANCE, SEPT. 1986, USA, Bd. 69, Nr. 2, Seiten 236-242, XP002134968 ISSN: 0022-2364**

## Beschreibung

Die Erfindung betrifft einen Probenkopf für ein NMR-Spektrometer, das mindestens eine Sendereinheit zur Erzeugung von hochfrequenten elektromagnetischen Anregungswellen und mindestens eine Vorverstärkereinheit zum Verstärken von Meßsignalen einer über die Anregungswellen angeregten Meßprobe aufweist, mit einem kryogenisch gekühlten primären Meßkreis, der mindestens eine erste Antenne und einen ersten Wellenleiter aufweist, wobei die Antenne über den ersten Wellenleiter mit der Vorverstärkereinheit verbunden ist.

Das Ziel eines NMR-Experiments ist es, eine elektromagnetische Strahlung zu beobachten, die durch Energieübergänge von Elektronen und/oder Atomkernen in einer Meßprobe als Reaktion auf eine Anregung durch ein Hochfrequenzfeld B, mit einer Frequenz $w_0$ in einem zeitlich und räumlich homogenen Magnetfeld $B_0$ verursacht werden. Die Frequenz $\omega_0$ der das Hochfrequenzfeld B, erzeugenden Anregungswelle liegt dabei bevorzugt im HF-Bereich und darüber bei ca. 300 MHz bis 3GHz. Die elektromagnetische Strahlung wird gegenüber dem allgemeinen Hintergrund elektromagnetischen Rauschens gemessen, das unter anderem von thermischen Schwankungen im primären Meßkreis und in der Meßprobe oder in der Umgebung verursacht wird.

Ein besonderes Problem bei den meisten NMR-Experimenten ist die Schwäche der aus der Meßprobe austretenden Signale, wobei die Signale manchmal durch eine Reaktion in der Meßprobe oder durch Strahlung absorbierende Bestandteile der Meßprobe zusätzlich abgeschwächt werden. Insofern wird ständig versucht, die Empfindlichkeit des Probenkopfes zu erhöhen und das Signal/Rausch-Verhältnis zu verbessern.

Um das Signal/Rausch-Verhältnis zu maximieren ist man bestrebt, die Feldstärke des konstanten homogenen Magnetfeldes $B_0$ und die Frequenz $\omega_0$ des begleitenden Hochfrequenzfeldes B, bis auf maximal mögliche Werte anzuheben. Gleichzeitig werden im primären Meßkreis möglichst gut leitende bis supraleitende Materialien bei möglichst geringen Temperaturen eingesetzt, um Leitungsverluste und das inhärente elektromagnetische Rauschen zu minimieren. Außerdem wird regelmäßig der primäre Meßkreis gegenüber durch Umgebungseinflüsse verursachtes Rauschen abgeschirmt.

Ein Probenkopf der oben genannten Art ist aus der US 5,258,710 bekannt. Er weist einen ersten und einen damit gekoppelten zweiten Resonator auf, wobei der zweite Resonator mit einer Sendereinheit gekoppelt ist und der erste Resonator die Meßprobe aufnimmt. Zur Anregung der Meßprobe wird ein Radiofrequenzsignal über den zweiten Resonator in den ersten Resonator eingekoppelt und die von dem ersten Resonator umfaßte Meßprobe mit diesem Signal bestrahlt. Danach verhält sich der erste Resonator wie eine Empfangsspule und gibt die empfangenen Meßsignale an den zweiten Resonator ab. Um das Signal/Rausch-Verhältnis zu verbessern, wird auf der einen Seite der Probenkopf zur Verringerung des thermischen Rauschens kryogenisch gekühlt und auf der anderen Seite zur Verbesserung der Signalstärke die Leitfähigkeit des Probenkopfes durch die Verwendung von supraleitenden Materialien erhöht.

Des weiteren ist aus der US 5,751,146 eine an einer Seite offene Oberflächenspule aus einem Leitermaterial mit hoher Konduktivität für NMR-Experimente bekannt, bei der das Leitermaterial mindestens das drei- bis fünffache der Dicke der Skintiefe aufweist, so daß der Hochfrequenzwiderstand des Leitermaterials nicht von den Ausmaßen des Leitermaterials beeinflußt wird.

Aus der US 3,769,618 ist es bekannt, zur Reduzierung der Leitungsverluste in Dünnfilm-Übertragungsleitungen in integrierten Schaltkreisen den Oberflächenwiderstand durch Ausnutzung des anomalen Skin effekts zu minimieren.

Aus der US 4,442,404 sind ein Verfahren und Mittel zur Verbesserung der Empfindlichkeit und des Signal-/Rauschabstands bei NMR-Messungen bekannt, bei dem ein Empfangsspulensystem im Bereich der Supraleitung in einem Temperaturbereich von unter in etwa 1,85°K betrieben wird, wobei als Kühlmittel Helium-II verwendet wird.

Obwohl bereits große Anstrengungen unternommen wurden, das Signal/Rausch-Verhältnis signifikant zu erhöhen, sind bislang keine NMR-Spektrometer bekannt, bei denen das Signal/Rausch-Verhältnis insbesondere für Meßproben mit geringer Abstrahlleistung zufriedenstellend ist.

Somit ist es eine Aufgabe der vorliegenden Erfindung, einen Probenkopf der eingangs genannten Art mit einer optimierten Effizienz der Antennen und Vorverstärkereinheit und mit signifikant verbessertem Signal/Rausch-Verhältnis zur Verfügung zu stellen.

Diese Aufgabe wird zum einen dadurch gelöst, daß mindestens der erste Wellenleiter im Bereich des anomalen Skineffekts arbeitet, wobei die mittlere freie Weglänge der Ladungsträger mindestens im ersten Wellenleiter größer als die elektromagnetische Skintiefe ist, und daß der primäre Meßkreis mit Mitteln zum kurzzeitigen Anpassen an seine charakteristische Impedanz zur schnellstmöglichen Ladungsanpassung versehen ist.

Der anomale Skineffekt mit seiner charakteristischen Skintiefe $\delta_{eff}$ tritt ein, sobald die freie Weglänge 1 der Leitungselektronen größer ist als die Eindringtiefe des elektromagnetischen Feldes $\delta_{em}$, $1 > \delta_{em}$. Die Leitungselektronen können dann insbesondere bei tiefen Temperaturen, eine mittlere freie Weglänge 1 im Bereich von Millimetern bis zu Zentimetern erreichen. In diesem Fall ist eine in bezug auf den Werkstoff des Wellenleiters im wesentlichen verlustlose Wellenleitung möglich, so daß das von der Antenne empfangene Meßsignal ohne eine signifikante Verminderung der Signalstärke die Vorverstärkereinheit erreicht und dort weiterverarbeitet werden kann.

Damit ein solcher Wellenleiter mit einem extrem niedrigen Leitungswiderstand als Resonator in kürzester Zeit mit einer Welle beladen werden kann, muß er kurzzeitig mit seiner charakteristischen Impedanz angepaßt werden. Gleiches muß geschehen, wenn die Energie der Anregungswelle nach erfolgter Anregung der Meßprobe vor dem Beginn der Messung dissipiert werden muß. Hierfür kann beispielsweise die Antenne mit einer über eine Pin-Diode zuschaltbaren Impedanz in eine charakteristische Impedanz transformiert werden.

Der besondere Vorteil solcher im Bereich des anomalen Skineffekts arbeitender Wellenleiter gegenüber supraleitenden Wellenleitern liegt in ihren besseren Leitereigenschaften, da bei ihnen insbesondere keine Probleme mit Flußquanten auftreten.

Der Einsatz von Wellenleitermaterialien, die eine Wellenleitung bei anomalem Skineffekt ermöglichen, ist ebenso vorteilhaft im Bereich der ersten und möglicher weiterer Antennen.

Bevorzugt sollte mindestens der erste Wellenleiter im Bereich des extrem anomalen Skineffekts arbeiten können, um Leitungsverluste auf ein absolutes Minimum zu reduzieren.

In diesem Zusammenhang haben sich insbesondere metallische Leiterwerkstoffe mit einem inhärenten Widerstandsverhältnis von $r_i \gtrsim 10^3$, vorzugsweise von $r_i \gtrsim 10^4$ als geeignet herausgestellt.

Das inhärente Widerstandsverhältnis $r_i = \rho_{RT}/ \rho_{LT}$ definiert sich aus inhärentem Widerstand des Leiterwerkstoffs $\rho_{RT}$ bei Raumtemperatur zu seinem inhärenten Widerstand $\rho_{LT}$ bei Tieftemperatur, vorzugsweise bei Temperaturen $\lesssim$ 20K. Auch sollte der inhärente Widerstand solcher Metalle möglichst wenig von dem umgebenden magnetischen Feld abhängig sein, also das Verhältnis

$$\Delta\rho/\rho = (\rho \ r_i, T, B\neq0) - \rho \ (r_i, T, B=0) \ ) \ / \ \rho \ (r_i, T, B=0),$$

wobei ρ der von dem inhärenten Widerstandsverhältnis $r_i$, der absoluten Temperatur T und dem anliegenden magnetischen Feld B abhängiger inhärenter Widerstand ist, möglichst gering sein, insbesondere den Wert $\Delta\rho/\rho \leq 5$ bei einer Temperatur von T $\leq$ 20K und einem inhärenten Widerstandsverhältnis von $r_i \geq 10^3$ nicht wesentlich überschreiten.

Als besonders geeignetes Metall hat sich höchstreines Aluminium herausgestellt. Bevorzugt ist Aluminium mit einem Reinheitsgrad von >99,9999 % (6N-Aluminium) und sehr geringen Defektkonzentrationen zu nennen.

Grundsätzlich ist jedoch Aluminium mit einer Reinheit von ≈ 99,9 % als Leiterwerkstoff auch noch verwendbar. Es ist jedoch zu beachten, daß sich der Oberflächenwiderstand $R_5$ des Leiters beim Übergang von anomalem zum elektromagnetischen Skineffekt um Größenordnungen ändert.

Auch ist es von besonderem Vorteil, wenn mindestens die inneren und äußeren Leiteroberflächen des ersten Wellenleiters die gleiche inhärente Leitfähigkeit aufweisen wie das Leiterinnere.

Grundsätzlich gilt auch dies für den gesamten primären Meßkreis. Hierzu kann der Leiterwerkstoff durch Tempern vollständig entspannt und die Leiteroberflächen beispielsweise mittels einer Elektropolitur so behandelt werden, daß die bei der Herstellung des Welllenleiters kaltverformte Oberflächenschicht vollständig entfernt wird. Zusätzlich können die Leiteroberflächen passiviert werden.

Hierdurch sind Oberflächenwiderstände im Bereich von $10^{-7}$ Ω bei Betriebsbedingungen von T $\leq$ 4K und einer magnetischen Feldstärke von 11,744 T oder auch höher erreichbar, ebenso wie insbesondere bei höchstreinem Aluminium ein Widerstandsverhältnis $r_i$ im Bereich von $10^5$.

In einer anderen bevorzugten Ausgestaltung sind Vorverstärkereinheit und Antenne schaltbar miteinander verbunden. Wenn während der Dauer der Anregung der Meßprobe die Verbindung unterbrochen ist, ist sichergestellt, daß die Vorverstärkereinheit währenddessen nicht mit von der Antenne empfangenen Anregungssignalen beaufschlagt wird. Somit wird erreicht, daß die Signale der Anregungswelle, die gegenüber den zu messenden, von der Meßprobe abgestrahlten Signalen wesentlich stärker sind, nicht die Verarbeitung der zu messenden Signale in der Vorverstärkereinheit beeinflussen.

Es ist grundsätzlich auch eine konstruktive Ausführung denkbar, bei der die Ausbreitungsrichtung der Anregungswelle orthogonal zu der Ausbreitungsrichtung der zu messenden Signale steht, die von der Antenne empfangen werden können, so daß selbst ohne eine Unterbrechung der Verbindung zwischen Vorverstärker und Antenne von der Antenne während der Dauer der Anregung keine Signale der Anregungswelle aufgenommen werden.

Als bevorzugt zu verwendendes kryogenes Medium hat sich Helium-II herausgestellt. Unter Helium-II wird hier flüssiges Helium unterhalb der λ - Linie verstanden. Unter anderem zeigt Helium-II anders als Helium-I aufgrund seiner superfluiden und damit suprawärmeleitenden Eigenschaften keine Neigung zum Sieden. Somit kann bei Einsatz von Helium-II als kryogenes Medium wirksam ein durch Sieden bedingtes Rauschen vermieden und damit der Rauschpegel insgesamt verringert werden.

So kann mit Helium-II eine Leistung von 6 · $10^4$ W/m$^2$ aufgrund eines Temperaturgradienten von 4,3 · $10^{-4}$ K/m transportiert werden, so daß eine 3 · $10^5$fache effektive Wärmeleitfähigkeit gegenüber Kupfer bei Raumtemperatur erreicht wird.

Die Betriebstemperatur des Probenkopfes liegt bevorzugt bei 1,85 K, bei dem Helium-II eine maximale Wärmeflußdichte hat.

Das Helium-II ist auch als dielektrisches Medium im ersten Wellenleiter ebenso wie in allen anderen Wellenleitern und der oder den Antennen verwendbar, da seine Eigenschaften mit einer Dielektrizitätskonstante $\in_r \approx 1{,}055$ und einem inhärenten Widerstand von $\rho_{et} \leq 10^{13}$ Ωm denen von Vakuum sehr ähnlich sind. Somit kann Helium-II in einer Doppelfunktion als kryogenes Medium und als Dielektrikum eingesetzt werden. Gleichwohl ist die Verwendung eines Vakuums als Dielektrikum nicht ausgeschlossen.

Auch ist es von Vorteil, wenn die Antenne im NMR-Spektrometer unterhalb des ersten Wellenleiters angeordnet ist. So kann sich bei Aufnahme des Betriebs des Spektrometers während des Abkühlens auf die Betriebstemperatur im primären Meßkreis bildendes Heliumgas entlang des ersten Wellenleiters hin zu einem Kryostaten nach oben entweichen und sammelt sich in jedem Fall nicht in der Antenne.

Die Aufgabe wird bei einem Probenkopf der eingangs genannten Art auch dadurch gelöst, daß ein zweiter Wellenleiter insbesondere über mindestens eine Öffnung mit dem ersten Wellenleiter gekoppelt sowie mit der Sendereinheit verbunden ist, und Mittel zum Einkoppeln der Anregungswelle vom zweiten Wellenleiter in den ersten Wellenleiter vorgesehen sind, durch die eine Ausbreitung der Anregungswelle in Richtung zur Vorverstärkereinheit hin unterdrückt wird.

Somit werden Anregungswellen in den ersten Wellenleiter in Richtung zur Antenne eingekoppelt, so daß die Antenne bei einer solchen Ausführungsform neben der Funktion des Empfangens von Signalen der Meßprobe die weitere Funktion hat, das $B_1$-Feld für die Anregung der Meßprobe zu erzeugen.

Durch die Mittel zum Einkoppeln der Anregungswelle vom zweiten Wellenleiter in den ersten Wellenleiter wird gewährleistet, daß die Vorverstärkereinheit nicht durch die gegenüber dem Meßsignal sehr großen Anregungswellen beeinflußt wird, so daß sie möglichst kurzzeitig nach Ende der Anregung der Meßprobe zu Beginn der Messung einsatzbereit ist.

Auf diese Weise wird erreicht, daß die für den Empfang schwacher hochfrequenter Signale kalibrierte Vorverstärkereinheit nicht durch eine Anregungswelle mit hoher Leistung gestört wird und sich diese Störung noch in die Meßdauer nach erfolgter Anregung der Meßprobe auswirkt. Folglich ist die Totzeit zum Empfangen von Meßsignalen ohne Störungen sehr kurz, so daß die Vorverstärkereinheit in kürzester Zeit bzw. sofort nach Beendigung der Anregung der Meßprobe betriebsbereit ist.

Es gibt verschiedene Möglichkeiten, die Ausbreitung der Anregungswellen in Richtung zur Vorverstärkereinheit hin zu unterbinden.

So können die Mittel zum Einkoppeln der Anregungswelle eine $\lambda/2$ - Umwegleitung umfassen und die Funktion eines Richtkopplers haben.

In dieser Ausführungsform wird die von dem zweiten Wellenleiter in den ersten Wellenleiter einzukoppelnde Anregungswelle geteilt, wobei beide Teilwellen getrennt, insbesondere in einem Abstand des ungeraden Vielfachen einer viertel Wellenlänge $(2n+1) \cdot \lambda/4$ (n=0,1,2...), in den ersten Wellenleiter einkoppeln und in Richtung zur Antenne in Phase geleitet werden, während sie in Richtung zur Vorverstärkereinheit hin um $\lambda/2$ phasenverschoben sind. Dadurch wird die erste Teilwelle als Anregungswelle bei entsprechender Transformation und Impedanzanpassung in die Antenne zur Anregung der Meßprobe geleitet und die dort zurückreflektierte Welle durch destruktive Interferenz mit der zweiten Teilwelle in Richtung zur Vorverstärkereinheit weitestgehend aufgehoben.

Eine andere Möglichkeit ist, daß der erste Wellenleiter zwischen dem Bereich der Einkopplung des zweiten Wellenleiters in den ersten Wellenleiter und der Vorverstärkereinheit Mittel zum Kurzschließen, insbesondere mindestens eine Pin-Diode, aufweist.

Der Kurzschluß erfolgt sinnvollerweise in einem Bereich des ersten Wellenleiters, bei dem die sich im ersten Wellenleiter ausbildende stehende Welle einen Spannungsknoten aufweist, da dort die oszillierenden Ströme am höchsten sind und somit durch einen Kurzschluß die Ausbreitung der Anregungswelle im ersten Wellenleiter in Richtung zur Vorverstärkereinheit hin wirksam unterbunden werden kann.

In einer bevorzugten Ausgestaltung dieser Ausführungsformen ist die Einkopplung der Anregungswelle von dem zweiten Wellenleiter in den ersten Wellenleiter schaltbar. Hierdurch kann die Sendereinheit jederzeit vom primären Meßkreis isoliert werden.

Ein geeigneter Schalter wird dadurch geschaffen, daß der zweite Wellenleiter als offen abgeschlossener Leitungsresonator ausgebildet ist, der in einem Abstand $n \cdot \lambda/2$ von der Öffnung im zweiten Wellenleiter zur Einkopplung in den ersten Wellenleiter in Richtung zur der Sendereinheit abgewandten Seite temporär über einem Entladungsspalt kurzgeschlossen werden kann.

Der Entladungsspalt kann dabei am offenen Ende des zweiten Welleneleiters zwischen den Leiterschichten liegen, so daß das Ende über eine Heliumplasma- oder Bogenentladung direkt am Entladungsspalt kurzgeschlossen werden kann.

Die Leiterschichten des zweiten Wellenleiters können aber auch an seinem Ende kurzgeschlossen sein, wobei dann eine der Leiterschichten unmittelbar vor dem kurzgeschlossenen Ende von dem Entladungsspalt unterbrochen ist. Der Entladungsspalt ist dann so bemessen, daß das Ende des zweiten Wellenleiters bei "offenem" Entladungsspalt offen abgeschlossen ist.

Der Schalter beruht auf der Wechselwirkung des offenen bzw. kurzgeschlossenen Endes des zweiten Wellenleiters mit einer dazu um $\lambda/2$ beabstandeten Öffnung zur Einkopplung der Anregungswelle in den ersten Wellenleiter. Eine in dem zweiten Wellenleiter transportierte Welle wird an dem kurzgeschlossenen Ende des zweiten Wellenleiters reflektiert, so daß sich eine stehende Welle ausbildet. Im Bereich der Öffnung liegt ein Spannungsknoten und damit ein oszillierendes Maximum (Antiknoten) des Magnetfeldes vor, das in den ersten Wellenleiter einkoppeln kann. Wird der Kurzschluß geöffnet, wird die im zweiten Wellenleiter transportierte Welle nunmehr am offenen Ende reflektiert, so daß sich die stehende Welle um $\lambda/4$ verschiebt. In diesem Fall liegt im Bereich der Öffnung am zweiten Wellenleiter ein Spannungsantiknoten an, der ein hohes Maß an Isolation erzeugt.

Um unnötiges Rauschen zu vermeiden, dürfen während der Übertragungszeit des Meßsignals keine Steuerströme für die Betätigung von Schaltern fließen. Deswegen ist es von Vorteil, wenn für die Betätigung des Schalters zur Änderung der Phasenlage der stehenden Welle keine gesonderten Steuerströme verwendet werden.

Dieser bevorzugt einzusetzende Schalter wird im Falle einer Heliumplasmaentladung über einen Laser, im Falle der Bogenentladung über die Anregungswelle gesteuert.

In einer bevorzugten Ausgestaltung dieses Schalters wird mindestens eine der Elektroden des Entladungsspaltes durch Helium-II gekühlt, wobei die Elektrode mit einem mindestens einen Zulauf und einen Ablauf aufweisenden Kanal für Helium-II in Kontakt steht und der Ablauf ein semipermeables Diaphragma aufweist.

Da sich das superfluide Helium-II in kürzester Zeit zu einer Wärmequelle hin bewegt, kann aufgrund des durch das Diaphragma gerichteten Helium-II-Stroms die Wärme direkt während ihrer Entstehung abgeführt werden.

In einer anderen bevorzugten Ausgestaltung des Schalters verzweigt der zweite Wellenleiter in zwei Leiterwege, die in einem Abstand von vorzugsweise $(2n+1) \cdot \lambda/4$ zueinander in den ersten Wellenleiter einkoppeln, wobei beide ein kurzgeschlossenes Ende aufweisen und über eine Kurzschlußschaltung um $(2n+1) \cdot \lambda/4$ verkürzbar sind.

In einer besonderen Ausführungsform dieser Schaltungskonstruktion weisen beide Leiterwege an ihrem Ende kurzgeschlossene Leiterlängen mit einer Länge von $(2n + 1) \cdot \lambda/4$, deren Eingang insbesondere mittels mindestens einer Pin-Diode kurzgeschlossen werden kann.

Während bei einem durch die Pin-Dioden erzeugten Kurzschluß am Eingang der Kavitäten ein Spannungsknoten der Anregungswelle erzeugt und die Anregungswelle in den ersten Wellenleiter eingekoppelt wird, wird dieser Spannungsknoten um $\lambda/4$ verschoben, wenn die Pin-Dioden die Leiterlängen freigeben, so daß die Anregungswelle nicht mehr in den ersten Wellenleiter einkoppeln kann.

Die beiden Leiterwege können so angeordnet sein, daß einer eine $\lambda/2$-Umwegleitung gegenüber dem anderen Leiterweg bildet und die beiden Leiterwege die Funktion eines Richtkopplers haben.

Beide bevorzugt zu verwendenden Schaltungsarten sind innerhalb von Bruchteilen von Nanosekunden schaltbar, so daß hierdurch eine extrem kurze Entkopplung der Sendereinheit von dem Meßkreis erfolgen kann. Dies wird dadurch erreicht, daß der zweite Wellenleiter bzw. einer der Leiterwege kurzzeitig mit seiner charakteristischen Impedanz terminiert werden kann, so daß der Wellenleiter einen endlichen Dämpfungswert aufweist und schnell mit der Anregungswelle beladen werden kann.

In einer anderen vorteilhaften Ausführungsform ist mindestens einer der Wellenleiter als koaxialer Leiter ausgebildet.

Koaxialleiter mit einem inneren, zylindrischen Leiter und einem äußeren, zylindrischen Leitermantel bieten im HF-Bereich den Vorteil einer gegenüber anderen Formen von Hohlwellenleitern gleichmäßigen und einer im Verhältnis zur Dicke des Mantels geringen Skintiefe. Die elektromagnetischen Felder breiten sich fast vollständig entlang des dazwischen liegenden Dielektrikum aus, so daß keine Streufelder erzeugt werden.

Auch bietet die Außenfläche des äußersten Leitermantels des Koaxialleiters eine gute Abschirmung gegen eine Einstrahlung elektromagnetischer Strahlung aus der Umgebung.

Auch können mehrere koaxiale Wellenleiter einen mehrfach koaxialen Leiter mit einer gemeinsamen Achse bilden. Der koaxiale Leiter weist dann neben einem zylindrischen Innenleiter zwei oder mehr voneinander durch ein dielektrisches Medium getrennte, koaxiale, zylindrische Leitermäntel auf, wobei die Außenfläche eines Mantels als innerer Leiter für den darüber angeordneten Mantel dient.

Auf diese Weise können zweifach, dreifach oder mehrfache koaxiale Wellenleiter mit einer gemeinsamen Achse aufgebaut werden mit jeweils einer Länge von $n \cdot \lambda/4$, die jeweils voneinander unabhängige Hochfrequenzströme leiten.

Somit ist es möglich, auf einfache Weise bei kompakter Bauart neben der bei NMR-Experimenten sehr oft benötigten Protonenfrequenz andere, vorzugsweise niedrigere Frequenzen in den Probenkopf einzuleiten. Die Einleitung einer Anregungswelle mit niedrigerer Frequenz aus einem äußeren koaxialen Leiter in einen inneren koaxialen Leiter erfolgt vorzugsweise an einem Impedanz-Nullpunkt, der gleichzeitig ein Spannungsknoten der Anregungswelle im inneren koaxialen Leiter ist. An dem Spannungsknoten ist eine hohe Isolation zwischen den Kanälen niedriger Frequenz und hoher Frequenz gewährleistet.

Weitere Einkopplungen für andere Frequenzen können über entsprechende Öffnungen und Impedanzanpassungen erfolgen.

Die Anregung der Meßprobe mit Pulssequenzen verschiedener Frequenzen ist zumeist für eine Bestimmung der in ihr enthaltenen Substanzen und deren Struktur notwendig. So werden die Kanäle höherer Frequenzen, meist der Protonenfrequenz, üblicherweise zur sogenannten Kreuzpolarisation sowie zur Dipolentkopplung und die Kanäle niedrigerer Frequenz zur Beobachtung, zum Dephasing oder für Kohärenztransfer verwendet.

In diesem Zusammenhang ist es ebenso von Vorteil, wenn der erste und der zweite Wellenleiter einen mehrfach koaxialen Leiter mit einer gemeinsamen Achse bilden. Hierdurch können die Wellenleiter sehr platzsparend zueinander angeordnet werden. Dies ist insbesondere dann vorteilhaft, wenn als dielektrisches Medium Helium-II verwendet wird, welches durch entsprechend positionierte semipermeable Diaphragmen durch den Fountain-Effekt zirkuliert und für eine ausreichende Wärmeabfuhr sorgt. Auch wird durch die kompakte Anordnung der Wellenleiter erreicht, daß die Dimensionen des Probenkopfes so gering wie möglich gehalten werden können, so daß der geringe Raum in einem supraleitenden Hochfeldmagneten optimal ausgenutzt wird.

Insbesondere wenn die koaxial ausgebildeten Wellenleiter aus einem Werkstoff bestehen, der einen Leistungstransport bei anomalem Skineffekt ermöglicht, ist ein Dämpfungsmaß von $\alpha \le 10^{-8}$ Np/m möglich. Somit sind solche koaxialen Wellenleiter nahezu verlustfrei.

Um das Signal/Rausch-Verhältnis darüber hinaus erheblich zu verbessern, ist in einer anderen erfindungsgemäßen Ausführungsform eine zweite Antenne vorgesehen, wobei die Antennen derart angeordnet sind, daß die erste Antenne das Meßsignal und das Rauschsignal im äquatorialen Nahfeld der Meßprobe und die zweite Antenne alleine das Rauschsignal im axialen Nahfeld der Meßprobe mißt.

Eine NMR-Meßprobe wird am besten durch einen Hertz'schen Dipol beschrieben, die von der Anregungswelle angeregt wird und selbst strahlt. Dieser Hertz'sche Dipol ist im Zentrum der ersten Antenne, die das hochfrequenten B,-Feldes in x-Richtung generiert, angeordnet, wobei sowohl das $B_1$-Feld als auch der Hertz'sche Dipol in gleicher Richtung senkrecht zu der in z-Richtung verlaufenden Längsachse der ersten Antenne orientiert sind.

Im Nahfeld des Hertz'schen Dipols ist die aufgrund der Anregung abgestrahlte Energie in seiner äquatorialen Ebene maximal, während in axialer Richtung keine solche Energie abgestrahlt wird. Demgegenüber wird das im wesentlichen thermisch bedingte Nyquist-Rauschen von der Meßprobe in alle Richtungen isotrop abgestrahlt. Dieses Nahfeldstrahlungsmuster bietet eine Möglichkeit, zwei unabhängige Signale gleichzeitig von einer Meßprobe zu empfangen, indem man die im Nahfeld der Meßprobe in äquatorialer Ebene sowie die in axialer Richtung abgestrahlte Energie mißt.

Die erste Antenne kann dabei in einer bevorzugten Ausführungsform als Resonator in Form eines beidseitig in Längsrichtung geschlitztes Rohres mit einem reaktiv kurzgeschlossenen Ende ausgebildet sein. Eine solche Ausgestaltung entspricht der derzeitig in hochauflösenden NMR-Experimenten verwendeten geschlitzten, sattelförmigen u.h.f.-Einwindungs-Helmholtz-Spule.

Um das Laden und Entladen des primären Meßkreises mit Anregungswellen in kürzester Zeit zu ermöglichen, kann der reaktive Kurzschluß kurzzeitig durch Zuschalten einer Impedanz in die charakteristische Impedanz transformiert werden.

Dabei kann die erste Antenne über eine λ/4-Transformation mit Kompensation der Frequenzabhängigkeit an den ersten Wellenleiter angekoppelt sein. Hierdurch wird die Impedanz des ersten Wellenleiters weitestgehend verlustlos an die Impedanz der Antenne angepaßt, so daß störende Reflexionen wirksam vermieden werden.

Die zweite Antenne läßt sich beispielsweise durch eine einfache, im Nahfeld der Meßprobe axial in Richtung des B,-Feldes ausgerichtete kurze elektrische oder magnetische Dipolantenne insbesondere mit vorgeschalteter Luneburg-Linse verwirklichen.

Die verschiedenen Lösungsansätze - das Ausnutzen des anomalen Skineffekts, die schaltbare Einkopplung der Anregungswelle und die damit verbundene Isolierung zwischen Sendereinheit und Vorverstärkereinheit, der Einsatz von Helium-II als kryogenes Medium und als Dielektrikum sowie auch die Ausnutzung der Nahfeldcharakteristik der angeregten Meßprobe - sind jeweils einzeln dazu geeignet, das Signal/Rausch-Verhältnis signifikant zu verbessern.

Gleichwohl ist festzustellen, daß bei Berücksichtigung aller Lösungsansätze die eingangs gestellte Aufgabe optimal gelöst wird. So sind bei NMR-Experimenten an Meßproben mit extrem schwachen Abstrahlsignalen Verbesserungen des Signal/Rausch-Verhältnisses auf Werte von weit über 50 im Vergleich zu heutigen bei Raumtemperatur betriebenen Probenköpfen erreichbar.

Im folgenden wird die Erfindung anhand von bevorzugte Ausführungsbeispiele darstellende Figuren erläutert.

Es zeigen

Fig. 1    ein Ersatzschaltbild möglicher bevorzugter Ausführungsformen der Erfindung,

Fig. 2    einen Längsschnitt möglicher bevorzugter Ausführungsformen der Erfindung,

Fig. 3    einen Querschnitt dieser Ausführungsformen entlang der Linie III-III in Figur 2,

Fig. 4    einen Querschnitt dieser Ausführungsformen entlang der Linie IV-IV in Figur 2,

Fig. 5    einen Querschnitt dieser Ausführungsformen entlang der Linie V-V in Figur 2,

Fig. 6    einen Querschnitt dieser bevorzugten Ausführungsformen entlang der Linie VI-VI in Figur 2 sowie

Fig. 7    eine isometrische Darstellung einer Antenne der bevorzugten Ausführungsformen samt ihrer λ/4-Ankopplung an den ersten Wellenleiter.

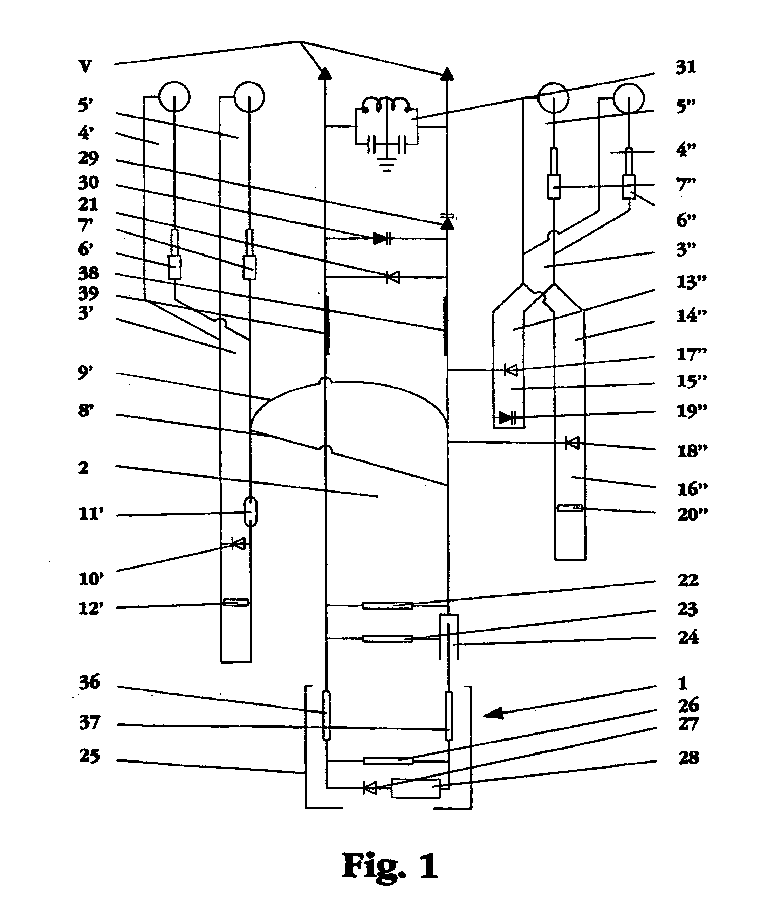

In Figur 1 ist ein Ersatzschaltbild für mögliche Ausführungsformen des erfindungsgemäßen Probenkopfes dargestellt.

Der Probenkopf weist eine erste Antenne **1** auf, die über das mit den Pfeilen **V** gekennzeichnete Ende eines ersten Wellenleiters 2 mit einer nicht dargestellten Vorverstärkereinheit **V** verbunden ist.

Darüber hinaus ist die Antenne **1** mit zwei Sendereinheiten verbunden. Im Ersatzschaltbild werden zwei verschiedene Ausgestaltungen der Ankopplung der Antenne 1 an die Sendereinheiten dargestellt, wobei die mit gekennzeichneten Bezugszeichen der einen und der mit " gekennzeichneten Bezugszeichen der anderen Ausgestaltung zuzuordnen sind. Die Ausgestaltungen unterscheiden sich durch die Art der Einkopplung der Anregungswellen in den ersten Wellenleiter 2.

Bei beiden Ausgestaltungen erfolgt die Einkopplung der Anregungswellen in den ersten Wellenleiter **2** über einen zweiten Wellenleiter **3', 3",** in den die Anregungswellen der Sendereinheiten von einem dritten Wellenleiter **4', 4"** und einem vierten Wellenleiter **5', 5"** an jeweils einem Spannungsknoten (Impedanzminimum) im zweiten Wellenleiter **3', 3"** einkoppeln. Dabei können beispielsweise Pulssequenzen mit einer u.h.f Frequenz über den dritten Wellenleiter **4', 4"** und mehrere Pulssequenzen niederer (h.f.-) Frequenzen über den vierten Wellenleiter **5', 5"** transportiert werden.

Die Impedanzanpassung vom dritten Wellenleiter **4', 4"** und vierten Wellenleiter **5', 5"** zum zweiten Wellenleiter **3', 3"** erfolgt über $\lambda/10$-Transformatoren **6', 6", 7', 7"** wie sie beispielsweise in Meinke/Gundlach, Taschenbuch der Hochfrequenztechnik, 5. Aufl., Bd. 2, S. L3 f., beschrieben sind.

Alle diese Wellenleiter sind als Koaxialwellenleiter mit zwei stromführenden Leiterschichten ausgebildet, genauso wie auch alle übrigen dargestellten Wellenleiter.

Die Ausgestaltungen unterscheiden sich in der Art der Einkopplung der Anregungswellen von dem zweiten Wellenleiter **3', 3"** in den ersten Wellenleiter **2.**

In der auf der linken Seite von Fig. 1 dargestellten Ausgestaltung wird die Anregungswelle der Sendereinheiten vom zweiten Wellenleiter **3'** in einen Wellenteiler eingekoppelt, durch den die Anregungswelle in zwei Teilwellen aufgeteilt wird. Der Wellenteiler umfaßt einen ersten Leiter **8'** und einen zweiten Leiter **9'**, wobei der zweite Leiter **9'** als $\lambda/2$ - Umwegleitung ausgebildet ist und beide Leiter 8', 9' in einem Abstand von $\lambda/4$ in den ersten Wellenleiter **2** einkoppeln. Im Wellenteiler wird die Phase der einen Teilwelle gegenüber der anderen Teilwelle in Richtung zur Vorverstärkereinheit **V** um $\lambda/2$ verschoben, so daß sich die im ersten Wellenleiter **2** ausbildende stehende Welle in Richtung zur Vorverstärkereinheit **V** hin aufhebt. Folglich hat diese Ausgestaltung die Funktion eines Richtkopplers, der die Anregungswellen nur in Richtung zur Antenne 1 hin passieren läßt.

Die Einkopplung der Anregungswelle in den Wellenteiler ist schaltbar. Hierfür weist der zweite Wellenleiter **3'** in einem Abstand von $\lambda/2$ zum Bereich der Einkopplung in den Wellenteiler einen Entladungsspalt **11'** auf, der je nach Ausführungsform über eine Heliumplasma- oder eine Bogenentladung kurzgeschlossen werden kann. Der Entladungsspalt ist dabei so bemessen, daß er dem zweiten Wellenleiter **3'** in nicht kurzgeschlossenem Zustand die Charakteristik eines offenen Leiterendes verleiht. Dadurch wird eine stehende Welle im zweiten Wellenleiter **3'** erzeugt, die im Bereich der Einkopplungsöffnung in den Wellenteiler einen Spannungsantiknoten aufweist, und damit die Einkopplung der Welle in den Wellenteiler unterbindet.

Die Entladung am Entladungsspalt **11'** wird entweder über die hochfrequente Anregungswelle selbst oder auch - im Falle der Heliumplasmaentladung - über eine Anregung durch einen Laser gezündet.

Während die Meßprobe von Anregungswellen angeregt wird, ist der zweite Wellenleiter **3'** unmittelbar hinter dem Entladungsspalt **11'** durch eine Pin-Diode **10'** kurzgeschlossen.

Nur kurzzeitig zu Beginn und zum Ende der Anregung der Meßprobe wird die Pin-Diode **10'** geschaltet, wodurch der Wellenleiter **3'** durch eine charakteristische Impedanzfolie **12'** angepaßt wird, die in einem Abstand von $\lambda/4$ hinter der Pin-Diode **10'** angeordnet ist. Der zweite Wellenleiter **3'** bekommt hierdurch den Charakter eines unendlichen Wellenleiters, so daß eine Beladung mit der Anregungswelle äußerst schnell - in einer Größenordnung von wenigen Nanosekunden - erfolgen kann. Gleichzeitig wird die an der Vorderseite der Impedanzfolie **12'** reflektierte Welle durch die vom in einem Abstand von $\lambda/4$ kurzgeschlossenen Ende des Wellenleiters reflektierte Welle annihiliert

Soll die Meßprobe angeregt werden, wird der Entladungsspalt **11"** kurzgeschlossen.

Dadurch ist der zweite Wellenleiter **3'** in einem Abstand von $\lambda/2$ vom Bereich der Einkopplung in den Wellenteiler kurzgeschlossen, so daß die sich im zweiten Wellenleiter **3'** ausbildende stehende Welle im Bereich der Einkopplung des Signals in den Wellenteiler einen Spannungsknoten aufweist und somit in den Wellenteiler einkoppeln kann.

Wird die Entladung beendet, verschiebt sich die stehende Welle der Anregungswelle aufgrund der Reflexion der Anregungswelle am nunmehr offenen Ende des zweiten Wellenleiters **3'** um $\lambda/4$, so daß im Bereich der Einkopplung ein Spannungsantiknoten besteht und die Anregungswelle nicht mehr in den Wellenteiler einkoppeln kann.

In der auf der rechten Seite von Fig. 1 dargestellten Ausgestaltung wird die Anregungswelle aus dem zweiten Wellenleiter **3"** in einen Wellenteiler mit einem ersten Leiter **13"** und einem zweiten Leiter **14"** eingekoppelt, durch den die Anregungswelle in zwei Teilwellen aufgeteilt wird. Beide Teilwellen werden in den ersten Wellenleiter **2** in einem Abstand von $\lambda/4$ eingekoppelt, wobei die Phase der einen, in den ersten Wellenleiter **2** eingekoppelten Teilwelle gegenüber der anderen, in den ersten Wellenleiter **2** eingekoppelten Teilwelle in Richtung zur Vorverstärkereinheit **V** um λ/2 verschoben ist, so daß sich die im ersten Wellenleiter **2** ausbildende stehende Welle in Richtung zur Vorverstärkereinheit **V** hin aufgrund destruktiver Interferenz aufhebt. Hierfür weisen die beiden Leiter **13", 14"** in dem Bereich der Öffnungen, die zur Einkopplung der Teilwellen in den ersten Wellenleiter **2** vorgesehen sind, Pin-Dioden **17", 18"** auf, mit denen im Bereich der Öffnungen ein Spannungsknoten der Teilwelle erzwungen werden kann.

Auch diese Ausgestaltung hat somit die Funktion eines Richtkopplers, der die Anregungswellen nur in Richtung zur Antenne hin passieren läßt.

Der Leiter **13"** endet nach der Einkopplungsöffnung in einer kurzgeschlossenen λ/4-Leitungslänge **15"**, in der ein Varaktor **19"** zur präzisen Abstimmung des Spannungsknotens für die Einkopplung und Teilung der Anregungswelle angeordnet ist. Der Leiter **14"** endet nach der Einkopplungsöffnung in einer kurzgeschlossenen λ/2 - Leitungslänge **16"**, die in ihrer Mitte eine als charakteristische Impedanz ausgebildete Folie **20"** zum kurzzeitigen Anpassen des Wellenleiters **3"** während des schnellstmöglichen Be- und Entladens mit der Anregungswelle aufweist.

Sind die Leiter **13", 14"** nicht durch ihre Pin-Dioden **17", 18"** kurzgeschlossen, verschieben sich die Spannungsknoten der stehenden Teilwellen um λ/4 hin zum kurzgeschlossenen Leiterende. Dadurch besteht im Bereich der Einkopplung der Teilwellen ein Spannungsantiknoten, so daß die Teilwellen nicht in den ersten Wellenleiter **2** einkoppeln können.

Über den Varaktor **19"** kann die Phase der sich in den beiden Leitern **13", 14"** ausbildenden stehenden Teilwellen der Anregungswelle genau abgestimmt werden. Die über die Pin-Diode **18"** kurzzeitig zuschaltbare charakteristische Impedanz **20"** dient in der oben geschilderten Art zum schnellen Laden und Entladen der Wellenleiter mit der Anregungswelle.

Eine zusätzliche Entkopplung der Vorverstärkereinheit **V** von der Anregungswelle kann auch dadurch erfolgen, daß der erste Wellenleiter **2** über die oberhalb des Bereichs der Einkopplung der Anregungswelle in den ersten Wellenleiter **2** angeordnete Pin-Diode **21** kurzzeitig kurzgeschlossen wird. Die Pin-Diode **21** ist hierfür in dem Bereich eines Spannungsknotens der sich im ersten Wellenleiter **2** ausbildenden stehenden Welle angeordnet.

Die Öffnungen zur Einkopplung von Teilwellen in den ersten Wellenleiter 2 werden vorzugsweise regelmäßig als umlaufende Schlitze ausgeführt.

Zur Vermeidung unerwünschter gegenseitiger Wechselwirkungen zwischen den diversen Anregungswellen verschiedener Sendereinheiten sowie dem Vorverstärker **V** sind diese durch entsprechende Bandsperr-Filter in koaxialer Bauform an ihren Aus- bzw. Eingängen zu schützen.

Am unteren Ende des ersten Wellenleiters **2** ist die Antenne **1** angeordnet. Ihre Impedanz ist an die des ersten Wellenleiters **2** über einen λ/4 - Transformator mit Kompensation der Frequenzabhängigkeit **22, 23, 24** in der Art, wie es in Meinke/Gundlach, a.a.O., beschrieben ist, angepaßt.

Die Antenne **1** ist als Resonator ausgestaltet. Sie weist einen induktiv angekoppelten Schirm **25** auf. Der reaktive Abschlußwiderstand **26** bewirkt, daß sich in der Antenne eine stehende Welle mit einem Spannungsknoten genau am Ort der Meßprobe ausbildet, wodurch die dielektrische Kopplung der Meßprobe stark reduziert wird. Darüber hinaus ist eine über eine Pin-Diode **27** zuschaltbare Impedanz **28** vorgesehen, so daß eine charakteristische Abschlußimpedanz entsteht. Auf der einen Seite kann der erste Wellenleiter hiermit in kürzester Zeit mit der Anregungswelle beladen werden. Auf der anderen Seite kann hiermit in der Antenne vorhandene Restenergie der Anregungswelle in kürzester Zeit dissipiert werden, wenn der Meßvorgang beginnen soll.

In analoger Weise wirkt alternativ als sehr schnell zuschaltbare charakteristische Abschlußimpedanz für den primären Meßkreis ein auf ein Saphirsubstrat aufgetragener, nichtinduktiver Oberflächenfilm **38, 39** aus einem harten Typ-II-Supraleiter wie beispielsweise NbN oder $Nb_3Sn$ mit etwa der Dicke der Ginzburg-Landau-Kohärenzlänge, dessen Oberfläche parallel zu $B_0$ orientiert ist, und der sich supraleitend problemlos in die praktisch perfekt leitende Leiterschicht des ersten Wellenleiters einfügen läßt. Mittels eines Halbleiter-Lasers kann dieser bei entsprechender Dimensionierung in Nanosekunden normalleitend und somit in eine charakteristische Impedanz verwandelt werden.

Die Antenne kann über im ersten Wellenleiter **2** angeordnete variable Kapazitäten **29, 30** auf Resonanz abgestimmt und über einen Symmetriertopf **31** an die Vorverstärkereinheit **V** angepaßt werden. Beides erfolgt in einem sich induktiv verhaltenden Bereich des ersten Wellenleiters **2.**

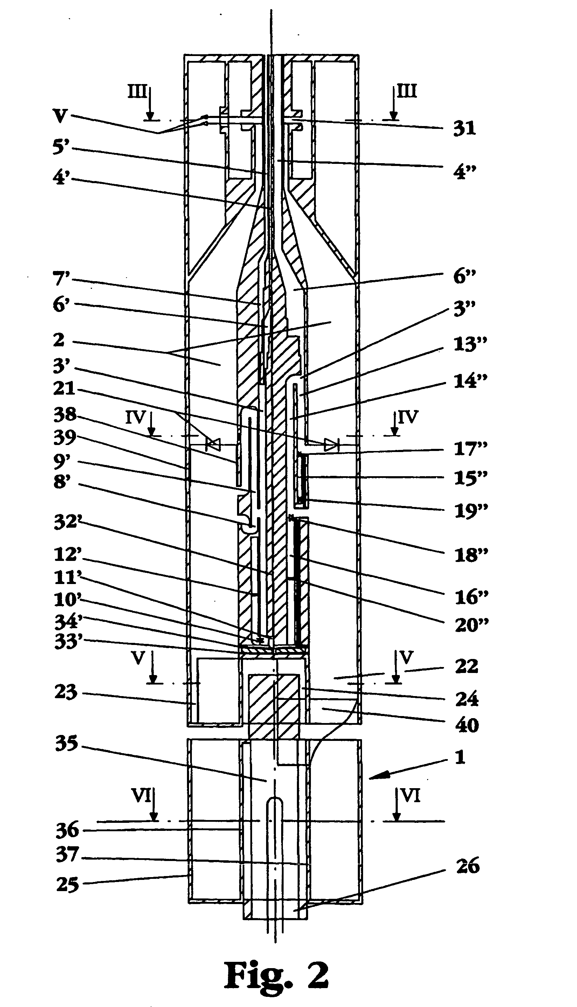

In Figur 2 ist eine der Figur **1** entsprechende Ausführungsform des Probenkopfes dargestellt. Dabei entspricht die links neben der Längsachse abgebildete Darstellung dem linken Teil der Figur 1 und die rechts neben der Längsachse abgebildete Darstellung im wesentlichen der rechten Seite der Figur 1.

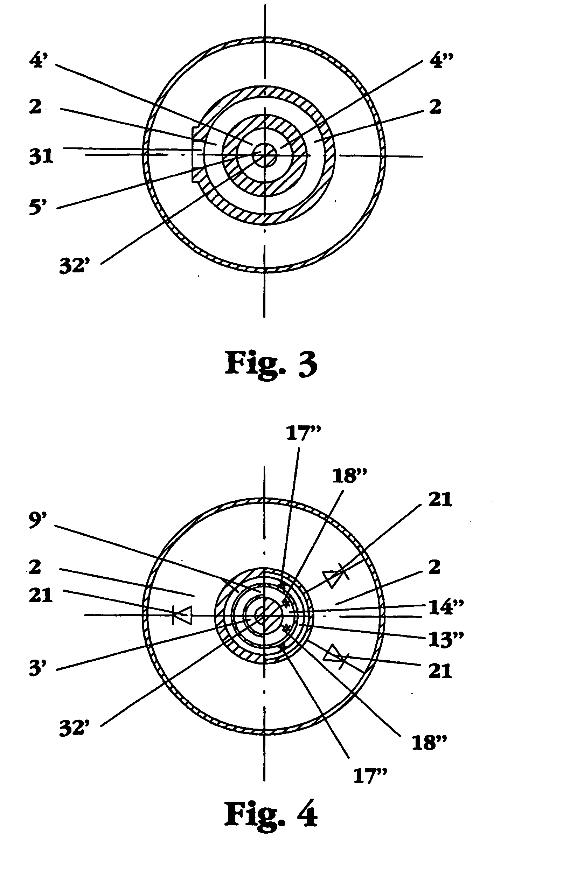

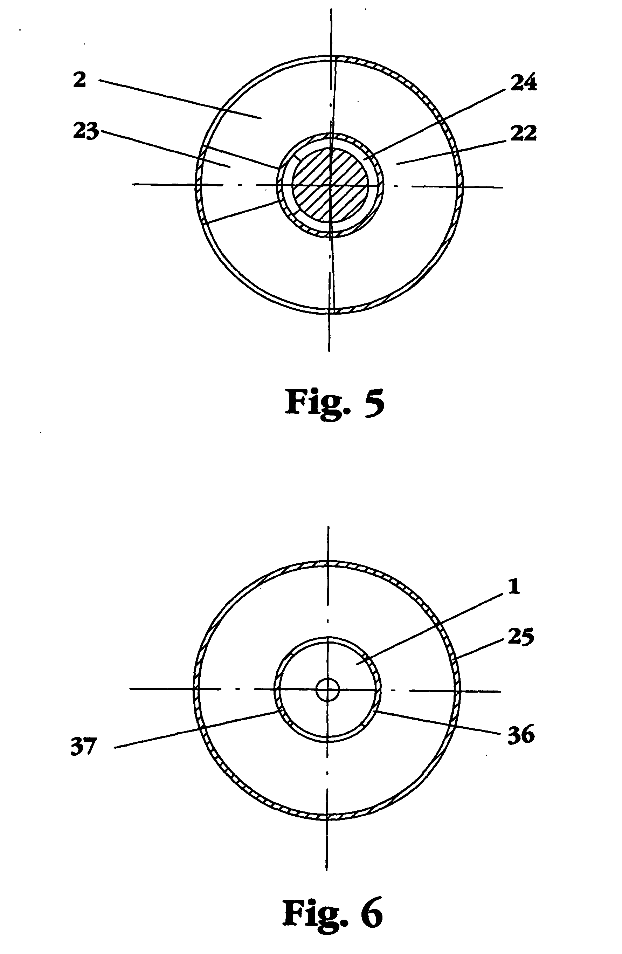

Wie insbesondere in Verbindung mit den Querschnitten dieser Ausführungsform zeigenden Figuren 3, 4, 5 und 6 deutlich wird, sind alle Wellenleiter **2, 3', 3", 4', 4" 5', 5", 6', 6", 7', 7", 8', 9', 13", 14", 15"** und **16"** als Koaxialleiter mit einer gemeinsamen Achse ausgebildet.

Die Koaxialleiter werden vollständig mit Helium-II gefüllt, das die Doppelfunktion als dielektrisches Medium und als Kühlmittel erfüllt.

Bei der auf der linken Seite dargestellten Ausführungsform ist der innerste Leiter des multikoaxialen Wellenleiters als Hohlzylinder ausgebildet, der von einem den Entladungsspalt **11'** bildenden Heliumplasmabehältnis aus Quarz oder Saphir abgeschlossen wird. Die Heliumplasmaentladung wird durch einen von einem im Hohlzylinder verlaufenden Lichtleiter **32'** geführten Laserstrahl gesteuert.

Eine Elektrode des Entladungsspalts **11'** ist von einem Kanal mit einem Zulauf **33'** und einem Ablauf **34'** für das Helium-II von und zum ersten Wellenleiter **2** zur Abfuhr der bei der Heliumplasmaentladung dissipierten Wärme durchzogen. Der Ablauf **34'** ist mit einem hier nicht dargestellten semipermeablen Diaphragma, beispielsweise aus einem $Al_2O_3$-Pulver, versehen, so daß ein Wärmeaustausch durch den Fountain-Effekt im Helium-II bewirkt wird. Dadurch ist gewährleistet, daß sich im Probenkopf ein Helium-II-Kreislauf ausbildet, wobei daß Helium-II die abgeleitete Wärme im Kryostaten abgibt.

In einer anderen nicht dargestellten Ausführungsform kann anstelle des in dem Kanal ausgebildeten Ablaufs der zweite Wellenleiter **3', 3''** als Ablauf mittels des Fountain-Effekts eingesetzt werden, da er ohnehin mit dem Kryostaten verbunden ist.

Alle Wellenleiterkomponenten des Probenkopfes sind sorgfältig aneinander angepaßt und miteinander verbunden, damit Reflexionen von elektromagnetischen Wellen vermieden werden. Auch sind alle Pin-Dioden **10', 17'', 18'', 21** und **27** einseitig durch einen entsprechenden Kondensator getrennt, damit sie durch einen Gleichstrom von einigen Milliampere gesteuert werden können, ohne von den hochfrequenten Wellen gestört zu werden.

Als mögliche einsetzbare Pin-Dioden sind unter anderem solche aus Galliumarsenid zu nennen.

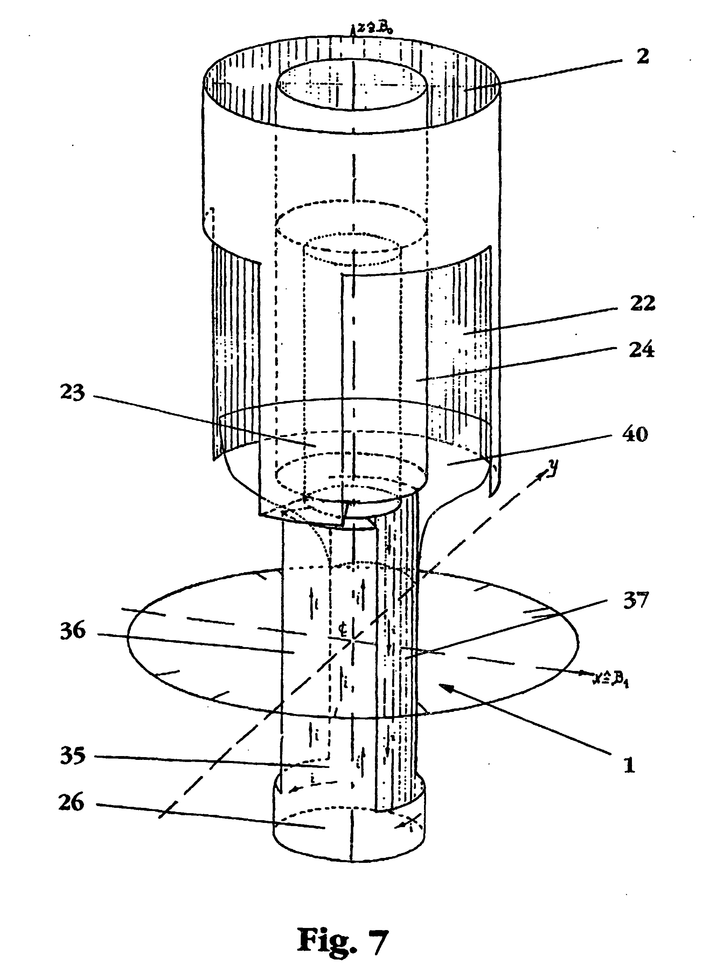

Die Antenne **1** ist in Figur 7 räumlich dargestellt. Sie besteht aus einem beidseitig in Richtung der Längsachse bis kurz vor seinem unteren Ende geschlitzten Rohr **35,** wobei sich die Schlitze über jeweils ca. 100° des Rohrumfangs erstrecken.

Das geschlitzte Rohr **35** kann durch einen kapazitiven Blindabschluß abgeschlossen werden (vgl. Meinke/Gundlach, Taschenbuch der Hochfrequenztechnik, 5. Aufl., Bd.1, C21).

Einer der durch die Schlitze gebildeten, in Längsrichtung verlaufenden Stege **37** ist über eine insbesondere in Figur 2 gezeigte, verlustfreie Dolph-Tschebyscheff-Leitung **40** mit der inneren Leiterfläche des Außenleiters des ersten Wellenleiters **2** verbunden. Der andere Steg **36** ist in Serie geschaltet mit einem konzentrisch zur Rohrachse verlaufenden, zylindrischen Rohrleiter, der sich in Richtung zum ersten Wellenleiter **2** hin erstreckt.

Der zylindrische Rohrleiter ist eine an ihrem oberen Ende offene λ/4-Transformationsleitung **24**. Die Außenseite des zylindrischen Rohrleiters dient als Innenleiter für die in geschlitzter Form ausgeführte λ/4-Leitung **23**. Die λ/4-Leitung **23** ist an ihrem unteren Ende kurzgeschlossen und schließt mit ihrem oberen Ende innen an den ersten Wellenleiter **2** an.

Während sich die Dolph-Tschebyscheff-Leitung **40** über ein Kreissegment von ca. 177° erstreckt, erstreckt sich die λ/4-Leitung **23** über ein Kreissegment von ca. 35°, wobei sich die Kreissegmente einander gegenüber liegen.

Sowohl die Verbindungsleitung, die den Steg **36** mit dem Innenleiter der λ/4-Transformationsleitung **24** verbindet, als auch die Verbindungsleitung, die das untere Ende der λ/4-Leitung **23** kurzschließt, können vorteilhaft ebenso als Dolph-Tschebyscheff-Leitungen ausgebildet sein.

Die Ankopplung der Antenne **1** an den ersten Wellenleiter **2** ist somit in der Art einer λ/4-Transformation mit Kompensation der Frequenzabhängigkeit ausgeführt, wie in Meinke/Gundlach, a.a.O. beschrieben.

In der dargestellten Anordnung bildet sich ein stehendes elektromagnetisches Wellenfeld zwischen den sich gegenüberliegenden Stegen senkrecht zur Rohrachse aus, wobei in seinem Zentrum, in dem sich die Meßprobe befindet, ein Spannungsknoten und damit ein hochfrequentes Magnetfeld besteht, das sehr homogen ist. Die Antenne **1** wirkt somit wie eine geschlitzte Einwindungs-Helmholtz-Spule analog den derzeit in hochauflösenden NMR-Spektrometern verwendeten.

In analoger Art und Weise können Antennen für ein oder mehrere Frequenzen für hochauflösende oder "magic angle spinning" sowie "cross-polarization" oder "decoupling" Experimente mit oder ohne Gradientenfelder an den ersten Wellenleiter angepaßt werden.

Die Meßprobe wird von unten in das Rohr des supraleitenden Hochfeldmagneten eingeführt. Sie ist durch ein Dewargefäß von den kryogenisch gekühlten Antennenelementen getrennt, so daß die Meßprobe bei Raumtemperatur oder einer anderen unabhängigen Temperatur untersucht werden kann.

In dem bevorzugten Probenkopf wird eine kryogenisch gekühlte Vorverstärkereinheit **V** verwendet, um auch in diesem Bereich eine Verminderung des Signal/Rausch-Verhältnisses durch thermisches Rauschen zu vermeiden. Als verwendbarer Vorverstärker kann insbesondere der von R. J. Prance et al. in Journal of Physics E: Scientific Instruments, Bd. 15, S. 101-104, 01.1982 "U.H.F. ultra low noise cryogenic FET preampliher" beschriebene eingesetzt werden.

Der gesamte Probenkopf einschließlich der Antenne **1** wird von einem in den Zeichnungen nicht dargestellten Durchlauf-Kryostaten mit Kryogenerator für geschlossenen Kreislaufbetrieb bei 1,85 K umschlossen, mit dem er von oben in einen supraleitenden Magneten mit senkrecht angeordneter Bohrung eingeführt werden, wobei im Bereich der Bohrung Raumtemperatur vorherrscht. Der Raum für die Meßprobe ist als nach oben einspringende Einstülpung in den Kryostaten ausgeführt.

**Patentansprüche**

**1.** Probenkopf für ein NMR-Spektrometer, das mindestens eine Sendereinheit zur Erzeugung von hochfrequenten elektromagnetischen Anregungswellen und mindestens eine Vorverstärkereinheit (V) zum Verstärken von Meßsignalen einer über die Anregungswellen angeregten Meßprobe aufweist, mit einem kryogenisch gekühlten primären Meßkreis, der mindestens eine erste Antenne (1) und einen ersten Wellenleiter (2) aufweist, wobei die Antenne (1) über den ersten Wellenleiter (2) mit der Vorverstärkereinheit (V) verbunden ist, **dadurch gekennzeichnet, daß** mindestens der erste Wellenleiter (2) im Bereich des anomalen Skineffekts arbeitet, wobei die mittlere freie Weglänge der Ladungsträger mindestens im ersten Wellenleiter (2) größer als die elektromagnetische Skintiefe ist, und **daß** der primäre Meßkreis mit Mitteln zum kurzzeitigen Anpassen an seine charakteristische Impedanz versehen ist.

2. Probenkopf nach Anspruch 1, **dadurch gekennzeichnet, daß** mindestens der erste Wellenleiter (2) im Bereich des extrem anomalen Skineffekts arbeitet.

3. Probenkopf nach Anspruch 1 oder 2, **dadurch gekennzeichnet, daß** mindestens der erste Wellenleiter (2) aus einem Metall mit einem möglichst hohen inhärenten Widerstandsverhältnis von r, $\gtrsim 10^4$ gebildet ist.

4. Probenkopf nach Anspruch 3, **dadurch gekennzeichnet, daß** mindestens für den ersten Wellenleiter (2) als Leiterwerkstoff höchstreines Aluminium eingesetzt wird.

5. Probenkopf nach einem der Ansprüche 3 oder 4, **dadurch gekennzeichnet, daß** mindestens die inneren und äußeren Leiteroberflächen des ersten Wellenleiters (2) die gleiche inhärente Leitfähigkeit aufweisen wie das Leiterinnere.

6. Probenkopf nach einem der vorstehenden Ansprüche, **dadurch gekennzeichnet, daß** Vorverstärkereinheit (V) und Antenne (1) schaltbar miteinander verbunden sind.

7. Probenkopf nach einem der vorstehenden Ansprüche, **dadurch gekennzeichnet, daß** als kryogenes Medium Helium-II eingesetzt wird.

8. Probenkopf nach Anspruch 7, **dadurch gekennzeichnet, daß** die Betriebstemperatur bei 1,85 K liegt.

9. Probenkopf nach Anspruch 7 oder 8, **dadurch gekennzeichnet, daß** das Helium-II in mindestens dem ersten Wellenleiter (2) als Dielektrikum verwendet wird.

10. Probenkopf nach Anspruch 9, **dadurch gekennzeichnet, daß** die Antenne (1) im NMR-Spektrometer unterhalb des ersten Wellenleiters (2) angeordnet ist.

11. Probenkopf nach einem der vorstehenden Ansprüche, **dadurch gekennzeichnet, daß** ein zweiter Wellenleiter (3', 3") insbesondere über mindestens eine Öffnung mit dem ersten Wellenleiter (2) gekoppelt sowie mit der Sendereinheit verbunden ist, und Mittel zum Einkoppeln der Anregungswelle vom zweiten Wellenleiter (3', 3") in den ersten Wellenleiter (2) vorgesehen sind, durch die eine Ausbreitung der Anregungswelle in Richtung zur Vorverstärkereinheit (V) hin unterdrückt wird.

12. Probenkopf nach Anspruch 11, **dadurch gekennzeichnet, daß** die Mittel zum Einkoppeln der Anregungswelle eine $\lambda/2$ - Umwegleitung (9') umfassen und die Funktion eines Richtkopplers haben.

13. Probenkopf nach Anspruch 11 oder 12, **dadurch gekennzeichnet, daß der erste** Wellenleiter (2) zwischen dem Bereich der Einkopplung des zweiten Wellenleiters (3', 3") in den ersten Wellenleiter (2) und der Vorverstärkereinheit (V) Mittel zum Kurzschließen, insbesondere mindestens eine Pin-Diode (21), **aufweist.**

14. Probenkopf nach einem der Ansprüche 11 bis 13, **dadurch gekennzeichnet, daß** die Einkopplung der Anregungswelle von dem zweiten Wellenleiter (3', 3") in den ersten Wellenleiter (2) schaltbar ist.

15. Probenkopf nach Anspruch 14, **dadurch gekennzeichnet, daß** der zweite Wellenleiter (3') als offen abgeschlossener Leitungsresonator ausgebildet ist, der in einem Abstand n · $\lambda/2$ von seiner Öffnung zur Einkopplung in den ersten Wellenleiter (2) in Richtung zur der Sendereinheit abgewandten Seite temporär über einem Entladungsspalt (11') kurzgeschlossen werden kann.

16. Probenkopf nach Anspruch 15, **dadurch gekennzeichnet, daß** mindestens eines der als Elektroden ausgebildeten Enden des Entladungsspaltes (11') durch Helium-II gekühlt wird, wobei die Elektrode mit einem mindestens einen Zulauf (33') und einen Ablauf (34') aufweisenden Kanal für Helium-II in Kontakt steht und der Ablauf (34') ein semipermeables Diaphragma aufweist.

17. Probenkopf nach Anspruch 14, **dadurch gekennzeichnet, daß** der zweite Wellenleiter (3") in zwei Leiterwege (13", 14") verzweigt, die in einem Abstand zueinander von vorzugsweise (2n+1) · $\lambda/4$ in den ersten Wellenleiter (2) einkoppeln, wobei beide ein kurzgeschlossenes Ende aufweisen und über eine Kurzschlußschaltung um (2n+1) · λ/4 verkürzbar sind.

18. Probenkopf nach Anspruch 17, **dadurch gekennzeichnet, daß** die beiden Leiterwege (13", 14") an ihrem Ende kurzgeschlossene Leiterlängen (15", 16") mit einer Länge von (2n + 1) · λ/4 aufweisen, deren Eingang insbesondere mittels mindestens einer Pin-Diode (17", 18") kurzgeschlossen werden kann.

19. Probenkopf nach einem der Ansprüche 11 bis 18, **dadurch gekennzeichnet, daß** mindestens einer der Wellenleiter als koaxialer Leiter ausgebildet ist.

20. Probenkopf nach Anspruch 19, **dadurch gekennzeichnet, daß** mehrere koaxiale Wellenleiter einen mehrfach koaxialen Leiter mit einer gemeinsamen Achse bilden.

21. Probenkopf nach einem der vorstehenden Ansprüche, **dadurch gekennzeichnet, daß** eine zweite Antenne vorgesehen ist, wobei die Antennen derart angeordnet sind, daß die erste Antenne

(1) das Meßsignal und das Rauschsignal im äquatorialen Nahfeld der als Hertz'scher Dipol strahlenden Meßprobe und die zweite Antenne alleine das Rauschsignal im axialen Nahfeld der Meßprobe mißt.

22. Probenkopf nach Anspruch 21, **dadurch gekennzeichnet, daß** die erste Antenne (1) als Resonator in Form eines beidseitig in Längsrichtung geschlitztes Rohres (35) mit einem kurzgeschlossenen Ende ausgebildet ist.

23. Probenkopf nach Anspruch 21 oder 22, **dadurch gekennzeichnet, daß** die erste Antenne (1) über eine λ/4-Transformation (22, 23, 24) mit Kompensation der Frequenzabhängigkeit an den ersten Wellenleiter (2) angekoppelt ist.

24. Probenkopf nach einem der Ansprüche 21 bis 23, **dadurch gekennzeichnet, daß** die zweite Antenne eine einfache, im Nahfeld der Meßprobe axial in Richtung des $B_0$-Feldes ausgerichtete, kurze elektrische oder magnetische Dipolantenne insbesondere mit vorgeschalteter Luneburg-Linse ist.

25. Verwendung von Helium-II in einem Probenkopf nach **einem der vorstehenden Ansprüche** als Dielektrikum in Wellenleitern.

## Claims

1. Probe head for a NMR-spectrometer comprising at least one transmitter unit for generating electromagnetic excitation waves of high frequencies and at least one preamplifier unit (V) for amplification of signals emanating from a sample which has been excited by means of the excitation waves, with a cryogenically cooled primary detection circuit including at least a first antenna (1) and a first waveguide (2), whereby said first antenna (1) is connected to said preamplifier unit (V) via said first waveguide (2), **characterized in that** at least said first waveguide (2) operates in the range of the anomalous skin effect, whereby the mean free path of the charge carriers at least in said first waveguide (2) being larger than the electromagnetic skindepth, and **in that** said primary detection circuit is provided with means for temporarily matching it with its own characteristic impedance.

2. Probe head according to claim 1, **characterized in that** at least said first waveguide (2) operates in the range of the extreme anomalous skin effect.

3. Probe head according to claim 1 or 2, **characterized in that** at least said first waveguide (2) is produced of a metal having a preferably high inherent resistivity ratio $r_i > \approx 10^4$.

4. Probe head according to claim 3, **characterized in that** at least for said first waveguide (2) aluminum of highest purity is being used as conductor material.

5. Probe head according to claim 3 or 4, **characterized in that** at least the interior and exterior conductor surfaces of said first waveguide (2) possess the same inherent conductivity as the interior of the conductor.

6. Probe head according to one of the foregoing claims, **characterized in that** said preamplifier unit (V) and said first antenna (1) are switchably interconnected.

7. Probe head according to one of the foregoing claims, **characterized in that** helium-II is used as cryogen.

8. Probe head according to claim 7, **characterized in that** the operating temperature is at about 1.85 K.

9. Probe head according to claim 7 or 8, **characterized in that** said helium-II is used at least within said first waveguide (2) as dielectric medium.

10. Probe head according to claim 9, **characterized in that** said first antenna (1) is arranged within the NMR-spectrometer below said first waveguide (2).

**11.** Probe head according to one of the foregoing claims, **characterized in that** a second wave guide (3', 3") is coupled in particular via at least one aperture to said first waveguide (2), that said second waveguide (3', 3") is connected with said transmitter unit, and means are provided for coupling the excitation wave from said second waveguide (3', 3") to said first wave guide (2), by which means the propagation of the excitation wave is suppressed in direction to said preamplifier unit.

**12.** Probe head according to claim 11, **characterized in that** said means for coupling the excitation wave comprise a $\lambda/2$-detour line (9') and operating like a directional coupler.

**13.** Probe head according to claim 11 or 12, **characterized in that**, that said first waveguide (2) comprises means for short-circuiting, in particular at least one pin-diode (21), between the area of the coupling of said second waveguide (3', 3") to said first waveguide (2) and said preamplifier unit.

**14.** Probe head according to one of the claims 11 to 13, **characterized in that** the coupling of the excitation wave from said second waveguide (3', 3") to said first waveguide (2) is switchable.

**15.** Probe head according to claim 14, **characterized in that** said second waveguide (3') is arranged in form of an open-circuited waveguide resonator, which can be short circuited temporarily via a discharge gap (11') in a distance of n $\lambda/2$ from said aperture for coupling to said first waveguide (2) in the direction opposite to the transmitter unit.

**16.** Probe head according to claim 15, **characterized in that** at least one of the electrodes of said discharge gap (11') is refrigerated by helium-II, whereby said electrode is equipped with a channel having at least one inlet (33') and one outlet (34') for helium-II, and whereby said outlet (34') is equipped with a semipermeable diaphragm.

**17.** Probe head according to claim 14, **characterized in that** said second waveguide (3") branches into two conducting paths (13", 14"), which couple preferably at a distance of (2n+1) $\lambda/4$ to said first waveguide (2), whereby each of the two conducting paths (13", 14") end in a termination which can be shortened by (2n+1)$\lambda/4$ by a switchable short circuit.

**18.** Probe head according to claim 17, **characterized in that** both conducting paths (13", 14") have at their ends short-circuited guides (15", 16") each with a length of <2n+1)$\lambda/4$ whose entrance in particular can be short-circuited by at least one pin-diode (17", 18").

**19.** Probe head according to one of the claims 11 to 18, **characterized in that** at least one of said waveguides is designed as a coaxial transmission line.

**20.** Probe head according to claim 19, **characterized in that** several coaxial transmission lines form one multiple coaxial transmission line with one common axis.

**21.** Probe head according to one of the foregoing claims, **characterized in that** a second antenna is provided, whereby said antennas are arranged such, that said first antenna (1) receives the NMR signal and the noise of said sample in the equatorial near-field of the like a Hertzian dipole radiating said sample and said second antenna receives only the noise of said sample in the axial near-field of said sample.

**22.** Probe head according to claim 21, **characterized in that** said first antenna (1) is designed as a resonator in the shape of a tube (35) slitted lengthwise on both sides with a termination that can be short-circuited.

**23.** Probe head according to claim 21 or 22, **characterized in that** said first antenna (1) is coupled via a $\lambda/4$-transformation (22, 23, 24) with frequency bandwidth compensation into said first wave guide (2).

**24.** Probe head according to one of the claims 21 to 23, **characterized in that** said second antenna is realized by an elementary short electric or magnetic dipole antenna oriented within the near-field of the sample axial in the direction of the $B_0$- field in particular with a Luneburg-lens.

**25.** Use of helium-II in a probe head according to one of the foregoing claims as dielectric medium within waveguides.

**Revendications**

**1.** Sonde pour spectromètre RMN comportant au moins une unité émettrice pour la génération d'ondes d'excitation électromagnétiques à haute fréquence et au moins une unité de préamplification (V) pour l'amplification de signaux de mesure d'un échantillon à mesurer excité par le biais des ondes d'excitation, avec un circuit de mesure primaire à refroidissement cryogénique comportant au moins une première antenne (1) et un premier guide d'ondes (2), l'antenne (1) étant reliée à l'unité de préamplification (V) par le biais du premier guide d'ondes (2),

**caractérisée en ce qu'**au moins le premier guide d'ondes (2) travaille dans la zone de l'effet de peau anomal, la longueur de parcours libre moyenne des porteurs de charge dans au moins le premier guide d'ondes (2) étant supérieure à la profondeur de peau électromagnétique, et **en ce que** le circuit de mesure primaire est pourvu de moyens pour l'adaptation temporaire à son impédance caractéristique.

2. Sonde selon la revendication 1, **caractérisée en ce qu'**au moins le premier guide d'ondes (2) travaille dans la zone de l'effet de peau anomal extrême.

3. Sonde selon la revendication 1 ou 2, **caractérisée en ce qu'**au moins le premier guide d'ondes (2) est réalisé dans un métal présentant un rapport de résistance intrinsèque le plus élevé possible de $r_1 \geq 10^4$.

4. Sonde selon la revendication 3, **caractérisée en ce que** de l'aluminium de grande pureté est mis en oeuvre en tant que matériau conducteur pour au moins le premier guide d'ondes (2).

5. Sonde selon l'une des revendications 3 ou 4, **caractérisée en ce qu'**au moins les surfaces de guidage intérieure et extérieure du premier guide d'ondes (2) présentent la même conductibilité intrinsèque que l'intérieur du guide.

6. Sonde selon l'une des revendications précédentes, **caractérisée en ce que** l'unité de préamplification (V) et l'antenne (1) sont reliées l'une à l'autre de manière commutable.

7. Sonde selon l'une des revendications précédentes, **caractérisée en ce qu'**il est fait appel à de l'hélium II en tant que produit cryogénique.

8. Sonde selon la revendication 7, **caractérisée en ce que** la température de fonctionnement est de 1,85 K.

9. Sonde selon la revendication 7 ou 8, **caractérisée en ce que** l'hélium II est utilisé dans au moins le premier guide d'ondes (2) en tant que diélectrique.

10. Sonde selon la revendication 9, **caractérisée en ce que** l'antenne (1) est disposée dans le spectromètre RMN au dessous du premier guide d'ondes (2).

11. Sonde selon l'une des revendications précédentes, **caractérisée en ce qu'**un second guide d'ondes (3', 3") est couplé avec le premier guide d'ondes (2) notamment par au moins une ouverture et est relié à l'unité émettrice, et **en ce que** des moyens de transmission de l'onde d'excitation du second guide d'ondes (3', 3") dans le premier guide d'ondes (2) sont prévus, grâce auxquels une propagation de l'onde d'excitation en direction de l'unité de préamplification (V) est atténuée.

12. Sonde selon la revendication 11, **caractérisée en ce que** les moyens de transmission de l'onde d'excitation comportent un circuit détourné $\lambda/2$ (9') et ont une fonction de coupleur directif.

13. Sonde selon la revendication 11 ou 12, **caractérisée en ce que** le premier guide d'ondes (2) présente, entre la zone du couplage du second guide d'ondes (3', 3") dans le premier guide d'ondes (2) et l'unité de préamplification (V), des moyens de mise en court-circuit, notamment au moins une diode Pin (21).

14. Sonde selon l'une des revendications 11 à 13, **caractérisée en ce que** la transmission de l'onde d'excitation du second guide d'ondes (3', 3") dans le premier guide d'ondes (2) est commutable.

15. Sonde selon la revendication 14, **caractérisée en ce que** le second guide d'ondes (3') est réalisé sous la forme d'un résonateur de ligne ouvert à ses extrémités pouvant être mis temporairement en court-circuit par le biais d'une fente de décharge (11') à une distance de $n \cdot \lambda/2$ de son ouverture de couplage dans le premier guide d'ondes (2) en direction du côté opposé à l'unité émettrice.

16. Sonde selon la revendication 15, **caractérisée en ce qu'**au moins l'une des extrémités en forme d'électrode de la fente de décharge (11') est refroidie à l'hélium II, l'électrode étant en contact avec un canal pour l'hélium II comprenant au moins une arrivée (33') et un départ (34'), le départ (34') étant pourvu d'un diaphragme semi-perméable.

17. Sonde selon la revendication 14, **caractérisée en ce que** le second guide d'ondes (3") se divise en deux guides (13", 14"), qui se couplent dans le premier guide d'ondes (2) de préférence à une distance de $(2n+1) \cdot \lambda/4$ l'une de l'autre, les deux présentant une extrémité en court-circuit et pouvant être raccourcis de $(2n+1) \cdot \lambda/4$ par le biais d'un circuit de court-circuit.

18. Sonde selon la revendication 17, **caractérisée en ce que** les deux guides (13", 14") présentent, à leur extrémité, des longueurs de guide (15", 16") d'une longueur de $(2n+1) \cdot \lambda/4$ mises en court-circuit, dont l'entrée peut être mise en court-circuit notamment par le biais d'au moins une diode Pin (17", 18").

19. Sonde selon l'une des revendications 11 à 18, **ca-**

**ractérisée en ce qu'**au moins l'un des guides d'ondes est configuré comme un guide coaxial.

20. Sonde selon la revendication 19, **caractérisée en ce que** plusieurs guides d'ondes coaxiaux forment un guide coaxial multiple avec un axe commun.

21. Sonde selon l'une des revendications précédentes, **caractérisée en ce qu'**une seconde antenne est prévue, les antennes étant disposées de telle sorte que la première antenne (1) mesure le signal de mesure et le signal de bruit dans le champ équatorial proche de l'échantillon à mesurer, qui rayonne comme in dipôle de Hertz, et que la seconde antenne mesure uniquement le signal de bruit dans le champ axial proche de l'échantillon à mesurer.

22. Sonde selon la revendication 21, **caractérisée en ce que** la première antenne (1) est réalisée en tant que résonateur sous la forme d'un tube (35) fendu des deux côtés dans le sens de sa longueur, avec une extrémité en court-circuit.

23. Sonde selon la revendication 21 ou 22, **caractérisée en ce que** la première antenne (1) est couplée au premier guide d'ondes (2) au moyen d'une transformation $\lambda/4$ (22, 23, 24) avec compensation de la variation suivant la fréquence.

24. Sonde selon l'une des revendications 21 à 23, **caractérisée en ce que** la seconde antenne est une simple antenne dipôle courte électrique ou magnétique, notamment avec une lentille de Luneburg en série, orientée, dans le champ proche de l'échantillon à mesurer, dans la direction du champ $B_0$.

25. Utilisation d'hélium II dans une sonde selon l'une des revendications précédentes en tant que diélectrique dans des guides d'ondes.

Fig. 1

**Fig. 2**

**Fig. 3**

**Fig. 4**

2

23

24

22

**Fig. 5**

1

25

37

36

**Fig. 6**

**Fig. 7**